# EUROPÄISCHE PATENTSCHRIFT

(11) **EP 1 246 260 B1**
(45) Veröffentlichungstag und Bekanntmachung des Hinweises auf die Patenterteilung: **09.01.2008**
(21) Anmeldenummer: 02006468.9
(22) Anmeldetag: 22.03.2002
(51) Int. Cl.: H01L 31/173, H01L 31/18, H01L 33/00

(54) **Optoelektronische Koppelvorrichtung und Herstellungsverfahren**
Optoelectronic coupling device and method of fabrication
Dispositif optoélectronique de couplage et méthode de fabrication

(30) Priorität: 29.03.2001 DE 10115440
(43) Veröffentlichungstag der Anmeldung: 02.10.2002
(73) Patentinhaber: Infineon Technologies AG, 81669 München (DE)
(72) Erfinder: Buchberger, Rudolf, 80469 München (DE); Halbritter, Hubert, 92345 Dietfurt - Töging (DE)
(74) Vertreter: Reinhard - Skuhra - Weise & Partner

(56) Entgegenhaltungen:
- EP-A- 0 645 827
- DE-A- 3 206 069
- US-A- 5 581 094
- KUO C-T ET AL: "INTEGRATED DEVICE BASED ON CONJUGATED OLIGOANILINE" POLYMERS FOR ADVANCED TECHNOLOGIES, JOHN WILEY AND SONS, CHICHESTER, GB, Bd. 13, Nr. 10-12, Oktober 2002 (2002-10), Seiten 753-758, XP001143824 ISSN: 1042-7147
- ALESSANDRELLO A ET AL: "A linear, low-noise, low-power optocoupler amplifier for bolometric detectors" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. 409, Nr. 1-3, 21. Mai 1998 (1998-05-21), Seiten 343-345, XP004133178 ISSN: 0168-9002

## Beschreibung

Die vorliegende Erfindung betrifft allgemein eine Vorrichtung zum Koppeln eines Eingangsschaltkreises mit einem Ausgangsschaltkreis, wobei der Eingangsschaltkreis von dem Ausgangsschaltkreis galvanisch trennbar ist, und betrifft insbesondere eine optoelektronische Koppelvorrichtung zur optischen Kopplung eines Eingangsschaltkreises mit einem Ausgangsschaltkreis und ein Herstellungsverfahren hierfür.

Eine galvanische Trennung von Schaltkreisen ist in vielen Anwendungsbereichen erforderlich, wenn es beispielsweise darum geht, dass eine elektrische Isolation zwischen einem Eingangsschaltkreis und einem Ausgangsschaltkreis bereitgestellt werden muss, oder wenn ein Ausgangsschaltkreis keine Rückwirkungen auf einen Eingangsschaltkreis hervorrufen darf. Soll der Ausgangsschaltkreis von dem Eingangsschaltkreis galvanisch vollständig getrennt werden, d.h. existiert keine elektrisch leitende Verbindung zwischen dem Eingangsschaltkreis und dem Ausgangsschaltkreis, so wird vorzugsweise Licht als Übertragungsmedium für Signale von dem Eingangsschaltkreis zu dem Ausgangsschaltkreis verwendet.

Hierzu wird in herkömmlicher Weise ein Eingangsschaltkreis an eine Lichtsendeeinheit angeschlossen, während ein Ausgangsschaltkreis an eine Lichtempfangseinheit angeschlossen wird, wobei zwischen der Lichtsendeeinheit und der Lichtempfangseinheit eine elektrische Isolation bereitgestellt wird, die lichtdurchlässig ist, d.h. von einer optischen Strahlung einer oder mehrerer Wellenlängen durchdringbar ist, um Signale von dem Eingangsschaltkreis zu dem Ausgangsschaltkreis zu übertragen.

Eine aus einer Lichtsendeeinheit, einer Lichtempfangseinheit und einer dazwischen liegenden elektrischen Isolationseinrichtung bzw. optischen Koppeleinrichtung bestehende Vorrichtung wird herkömmlicherweise als optoelektronische Koppelvorrichtung bzw. "Opto-Koppler" bezeichnet. Derartige OptoKoppler sind in vielfältiger Weise im Einsatz und beispielsweise aus "http://www.benjamin-eisenbeis.de/Ampelanlage/5b.htm" und aus "Profos/Pfeiffer: Handbuch der industriellen Messtechnik, Oldenburg-Verlag, 1992, Seite 185" bekannt und in vielfältigen Ausführungsformen kommerziell erhältlich.

Lichtsendeeinrichtungen, wie beispielsweise LED (Lichtemittierende Dioden), und Lichtempfangseinrichtungen, wie beispielsweise Fotodioden, werden nach dem Stand der Technik jeweils einzeln mit unterschiedlichen Verfahren der Dünnschichttechnologie hergestellt. Derartige Präparationensverfahren und Eigenschaften dünner Filme, insbesondere auch ITO-Schichten (ITO = Indium Tin Oxide, Indiumzinnoxid), sind aus "Hutchins et al., Phys. Stat. Technol.(a), Vol. 175, Seiten 991 - 1002, (1999)" bekannt.

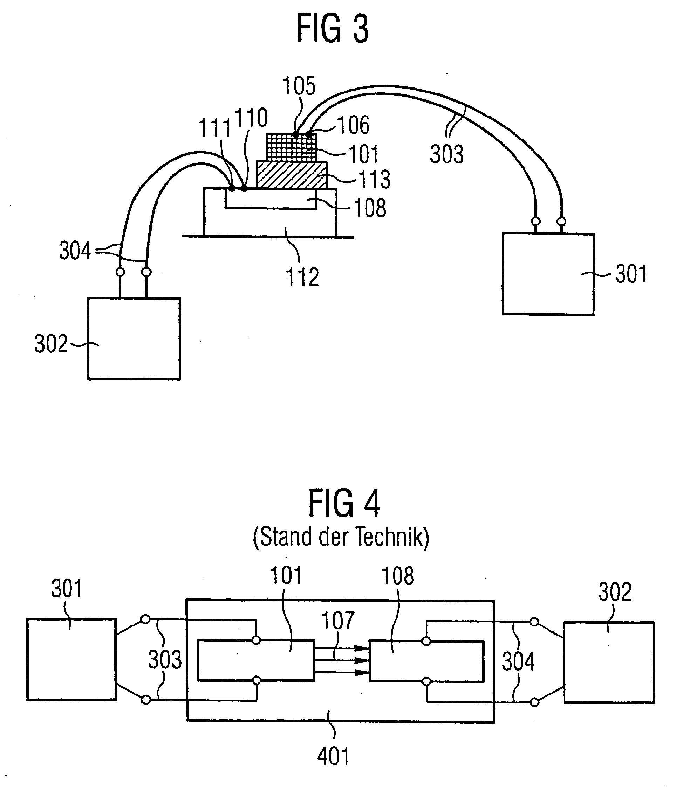

Bei der in Figur 4 gezeigten herkömmlichen Anordnung eines optoelektronischen Kopplers wird ein Eingangsschaltkreis 301 galvanisch von einem Ausgangsschaltkreis 302 getrennt, wobei die optoelektronische Koppelvorrichtung als ein Einzelkoppelelement 401 ausgebildet ist. Der Eingangsschaltkreis 301 ist über Eingangssignalleitungen 303 mit dem Einzelkoppelelement 401 verbunden, während der Ausgangsschaltkreis 302 über Ausgangssignalleitungen 304 mit dem Einzelkoppelelement 301 verbunden ist. Das Einzelkoppelelement 401 schließt eine einzelne Lichtsendeeinheit 101 und eine separate, einzelne Lichtempfangseinheit 108 ein, die sich derart gegenüber stehen, dass von der Lichtsendeeinheit 101 ausgesandtes Licht 107 von der Lichtempfangseinheit 108 empfangen wird.

Ein Hauptnachteil derartiger Einzelkoppelelemente 401 nach dem Stand der Technik besteht darin, dass die Lichtsendeeinheit 101 getrennt von der Lichtempfangseinheit 108 aufgebaut ist, was eine Integrationsmöglichkeit, z.B. in einer Wafer-Ebene, einer Chip-Ebene oder dergleichen nicht gestattet.

Weiterhin ist es ein Nachteil, dass mehrfache Opto-Koppler-Chip-Anordnungen nicht bereitgestellt werden können.

In nachteiliger Weise können optoelektronische Koppelvorrichtungen, die für mehrfache galvanische Entkopplungen von mehrfachen Ausgangsschaltkreisen und mehrfachen Eingangsschaltkreisen verwendet werden, nicht bereitgestellt werden.

Das Dokument EP-A-0645827 beschreibt eine optoelektronische Koppelvorrichtung mit einer Lichtsendeeinheit und einer Lichtempfangseinheit.

Es ist somit eine Aufgabe der vorliegenden Erfindung, eine optoelektronische Koppelvorrichtung zur optischen Kopplung eines Eingangsschaltkreises mit einem Ausgangsschaltkreis bereitzustellen, bei welcher eine Lichtsendeeinheit, eine Koppelschicht und eine Lichtempfangseinheit als eine Einheit auf einem einzigen Substrat ausgebildet ist, wobei eine Integrierbarkeit und eine mehrfache Anordnung der optoelektronische Koppelvorrichtung ermöglicht wird.

Diese Aufgabe wird durch eine optoelektronische Koppelvorrichtung mit den Merkmalen des Anspruchs 1 und ein Herstellungsverfahren nach Anspruch 11 bereitgestellt.

### VORTEILE DER ERFINDUNG

Die erfindungsgemäße optoelektronische Koppelvorrichtung mit den Merkmalen des Anspruchs 1 und das Herstellungsverfahren hierfür nach Anspruch 11 weisen folgende Vorteile auf.

Ein Hauptvorteil ist eine Verbindung einer Lichtsendeeinheit mit einer Lichtempfangseinheit über eine Koppelschicht, welche es erlaubt, eine opto-elektronische Koppelvorrichtung in einer Wafer-Ebene, als System auf einem Chip, mittels eines standardisierten Herstellungsprozesses auszuführen.

In vorteilhafter Weise wird ein Testen der optoelektronischen Koppelvorrichtung auf Fehler erleichtert.

In den Unteransprüchen finden sich vorteilhafte Weiterbildungen und Verbesserungen des jeweiligen Gegenstandes der Erfindung.

Gemäß einer bevorzugten Weiterbildung der vorliegenden Erfindung enthält eine Lichtsendeeinheit einer opto-elektronischen Koppelvorrichtung eine organische lichtemittierende Diode (LED = lichtemittierende Diode), wobei eine organische lichtemittierende Schicht zwischen einer Kathodenschicht und einer Anodenschicht eingebracht ist.

Gemäß einer weiteren bevorzugten Weiterbildung der vorliegenden Erfindung ist eine Isolationsschicht zur Isolation der Kathodenschicht von der Anodenschicht der Lichtsendeeinheit bereitgestellt, die aus Polyimid besteht.

Gemäß noch einer weiteren bevorzugten Weiterbildung der vorliegenden Erfindung besteht die Kathodenschicht aus AlCa.

Gemäß noch einer weiteren bevorzugten Weiterbildung der vorliegenden Erfindung besteht die Anodenschicht aus einer ITO-Schicht (ITO = Indium Tin Oxide, Indiumzinnoxid).

Gemäß noch einer weiteren bevorzugten Weiterbildung der vorliegenden Erfindung besteht eine Koppelschicht zur galvanischen Trennung der Lichtsendeeinheit von der Lichtempfangseinheit aus einer Isolierungsschicht wie beispielsweise Polyimid oder Glas.

Gemäß noch einer weiteren bevorzugten Weiterbildung der vorliegenden Erfindung ist der Eingangsschaltkreis als ein Treiberbaustein ausgebildet, der die Lichtsendeeinheit treibt.

Gemäß noch einer weiteren bevorzugten Weiterbildung der vorliegenden Erfindung ist der Ausgangsschaltkreis als ein weiterer Chip ausgebildet, um eine Mehrfach-Chip-Verpackung bereitzustellen.

Gemäß noch einer weiteren bevorzugten Weiterbildung der vorliegenden Erfindung ist die optoelektronische Koppelvorrichtung mittels einer Schicht, die aus Aluminiumoxid (Al₂O₃) besteht, gekapselt.

Gemäß noch einer weiteren bevorzugten Weiterbildung der vorliegenden Erfindung wird ein Koppelpfad als eine Isolierstrecke auf Wafer-Ebene realisiert.

Gemäß noch einer weiteren bevorzugten Weiterbildung der vorliegenden Erfindung kann die optoelektronische Koppelvorrichtung auf Wafer-Ebene hergestellt und getestet werden.

Gemäß noch einer weiteren bevorzugten Weiterbildung der vorliegenden Erfindung wird in der Lichtempfangseinheit ein mittels eines standardisierten Silizium-Prozesses hergestellter Fototransistor eingesetzt.

Gemäß noch einer weiteren bevorzugten Weiterbildung der vorliegenden Erfindung wird als Koppelschicht eine isolierende Polyimidschicht einer Dicke von 1-10 µm aufgebracht.

Gemäß noch einer weiteren bevorzugten Weiterbildung der vorliegenden Erfindung werden die optoelektronische Koppelvorrichtung ausbildenden Schichten strukturiert aufgebracht.

Gemäß noch einer weiteren bevorzugten Weiterbildung der vorliegenden Erfindung wird die Anodenschicht durch ein Sputtern von ITO-Material aufgebracht.

Gemäß noch einer weiteren bevorzugten Weiterbildung der vorliegenden Erfindung wird die Anodenschicht in einer Dicke von 50-200 nm abgeschieden.

Gemäß noch einer weiteren bevorzugten Weiterbildung der vorliegenden Erfindung wird die organische lichtemittierende Schicht durch eine Spin-Beschichtung mit einer Dicke von 200 nm aufgebracht.

Gemäß noch einer weiteren bevorzugten Weiterbildung der vorliegenden Erfindung wird die Kathodenschicht durch ein Aufdampfen von AlCa mit einer Dicke von 200 nm aufgebracht.

### ZEICHNUNGEN

Ausführungsbeispiele der Erfindung sind in den Zeichnungen dargestellt und in der nachfolgenden Beschreibung näher erläutert.

In den Zeichnungen zeigen:
- Figur 1: eine optoelektronische Koppelvorrichtung gemäß einem Ausführungsbeispiel der vorliegenden Erfindung;
- Figur 2: eine optoelektronische Koppelvorrichtung gemäß einem weiteren Ausführungsbeispiel der vorliegenden Erfindung;
- Figur 3: ein Anwendungsbeispiel der erfindungsgemäßen optoelektronischen Koppelvorrichtung; und
- Figur 4: eine optoelektronische Koppelvorrichtung nach dem Stand der Technik.

### BESCHREIBUNG DER AUSFÜHRUNGSBEISPIELE

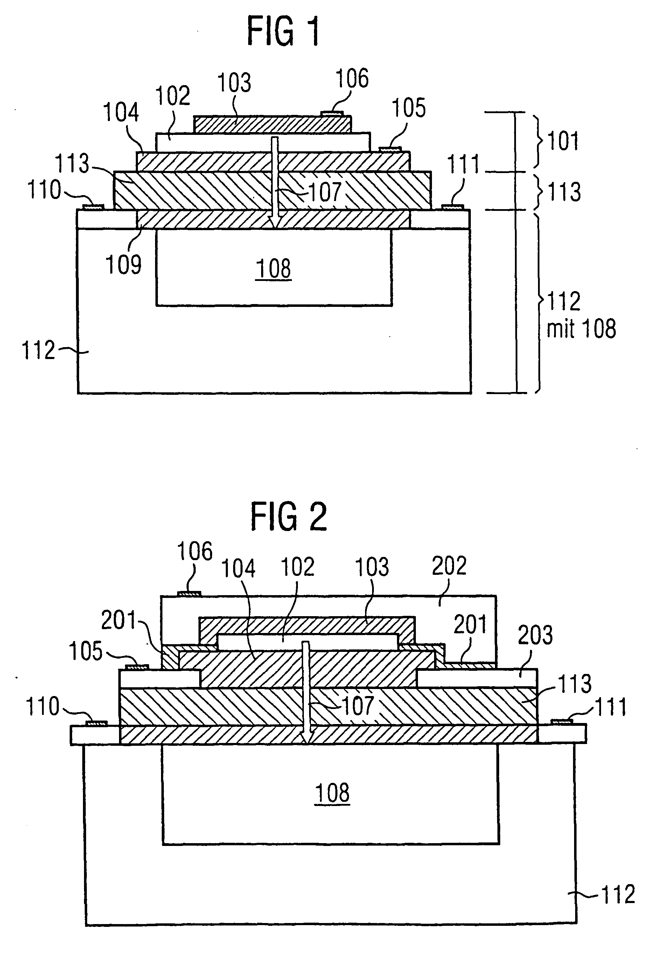

Figur 1 zeigt eine optoelektronische Koppelvorrichtung gemäß einem Ausführungsbeispiel der vorliegenden Erfindung.

Bei der in Figur 1 gezeigten Anordnung ist eine Lichtempfangseinheit 108 in einem Substrat 112 mittels eines standardisierten Silizium-Prozesses eingebracht. Die Lichtempfangseinheit 108 besteht zweckmässigerweise aus einem Fototransistor, der Licht 107 in ein elektrisches Signal wandelt. Auf diese Lichtempfangseinheit 108 ist eine Störsignalableitschicht 109 aufgebracht, die dazu dient, Gleichtaktstörungen etc. abzuleiten.

Die Störsignalableitschicht 109 ist für das Licht 107 durchlässig, wird oberhalb der fotoempfindlichen Fläche beispielsweise aus einem ITO-Material (ITO = Indium Tin Oxide, Indiumzinnoxid) aufgebracht und ist elektrisch leitfähig. Zwei Empfängerbondierungsanschlüsse 110, 111 dienen einer Ableitung eines Ausgangssignals der Lichtempfangseinheit, wobei die Details einer Verbindung der Empfängerbondierungsanschlüsse 110, 111 mit dem Fototransistor aus Gründen der Übersichtlichkeit weggelassen sind.

Gemäß dem erfindungsgemäßen Verfahren wird als Isolationsschicht auf die Störsignalableitschicht 109 eine Koppelschicht 113 aufgebracht, welche für das Licht 107 durchlässig ist, aber eine elektrische Isolation bereitstellt. Auf der Koppelschicht 113 wird schliesslich eine Anodenschicht 104 aufgebracht, welche eine Anode einer Lichtsendeeinheit 101 bildet, wobei die Anode durch einen Senderbondierungsanschluss 105 elektrisch mit einem Eingangsschaltkreis 301 verbunden werden kann.

Die Dicke der Anodenschicht 104 beträgt typischerweise 50-200 nm, während die Dicke der Koppelschicht 113 typischerweise 1-10 µm beträgt. Die organische lichtemittierende Schicht 102 weist eine Dicke von ca. 200 nm auf und wird vorzugsweise durch eine Spin-Beschichtung aufgebracht. Auf die organische lichtemittierende Schicht 102 wird eine Kathodenschicht 103 vorzugsweise durch ein Aufdampfen von AlCa aufgebracht, wobei die Dicke der Kathodenschicht 103 vorzugsweise 200 nm beträgt.

Ein zweiter Senderbondierungsanschluss 106 dient einer zweiten Verbindung des Eingangsschaltkreises 301 mit der Lichtsendeeinheit 101. Es sei daraufhingewiesen, dass die Lichtsendeeinheit 101, die Koppelschicht 113 und das Substrat 112, welches die Lichtsendeeinheit 108 beinhaltet, als eine Einheit ausgeführt sind, wobei die Einheit auf einem einzigen Substrat (Ein-Chip-Anordnung) bereitgestellt sind.

Figur 2 zeigt eine optoelektronische Koppelvorrichtung gemäß einem weiteren Ausführungsbeispiel der vorliegenden Erfindung.

Bei der in Figur 2 gezeigten Anordnung ist zusätzlich zu der in Figur 1 gezeigten Anordnung eine Anodenleiterbahn 203 bereitgestellt, die eine Strukturierung der Anodenschicht 104 erlaubt. Eine Isolationsschicht 201 dient einer Isolierung der Kathodenschicht 103 von der Anodenschicht 104. Hierbei wird die organische lichtemittierende Schicht 102 von der Kathodenschicht 103 und der Isolationsschicht 201 umschlossen.

Es sei daraufhingewiesen, dass gleiche Bezugszeichen wie in Figur 1 gleiche oder funktionsgleiche Komponenten bezeichnen, wobei, um eine überlappende Beschreibung zu vermeiden, eine Erklärung dieser Komponenten weggelassen ist. Weiterhin ist in Figur 2 gezeigt, wie eine Abdeckungsschicht 202 auf der Kathodenschicht 103 und der Isolationsschicht 201 aufgebracht ist, um die Lichtsendeeinheit 101 und damit die optoelektronische Koppelvorrichtung insgesamt hermetisch zu kapseln. Ein Senderbondierungsanschluss 106 ist zur Kontaktierung der Kathodenschicht 103 bereitgestellt.

Figur 3 verdeutlicht ein Anwendungsbeispiel der erfindungsgemäßen optoelektronischen Koppelvorrichtung.

Bei dem in Figur 3 gezeigten Anwendungsbeispiel ist ein Eingangsschaltkreis 301 mit der Lichtsendeeinheit 101 über Eingangssignalleitungen 303 und die Senderbondierungsanschlüsse 105, 106 verbunden. Ein Ausgangsschaltkreis 302 ist über die Empfängerbondierungsanschlüsse 110, 111 und Ausgangssignalleitungen 304 mit der Lichtempfangseinheit 108 verbunden. Als Eingangsschaltkreis 301 kann beispielsweise ein Treiberbaustein dienen, der die Lichtsendeeinheit 101 treibt, während als Ausgangsschaltkreis 302 ein weiterer Chip in einer Mehrfach-Chip-Packung angeordnet sein kann. Es ist durch die erfindungsgemäße optoelektronische Koppelvorrichtung somit möglich, mittels standardisierter Silizium-Prozesse eine Mehrfach-Chip-Verpackung und eine hohe Integrationsfähigkeit zu erreichen.

Weiterhin ist es möglich, durch ein Sägen des Substrats 112 entlang von Sägegräben, die zwischen den einzelnen optoelektronischen Koppelvorrichtungen bereitgestellt sind, Einzel-Chip-Koppelvorrichtungen oder Mehrfach-Chip-Koppelvorrichtungen zu erhalten.

Obwohl die vorliegende Erfindung vorstehend anhand bevorzugter Ausführungsbeispiele beschrieben wurde, ist sie darauf nicht beschränkt, sondern auf vielfältige Weise modifizierbar.

### Bezugszeichenliste

| | |
|---|---|
| 101 | Lichtsendeeinheit |
| 102 | Organische lichtemittierende Schicht |
| 103 | Kathodenschicht |
| 104 | Anodenschicht |
| 105, 106 | Senderbondierungsanschlüsse |
| 107 | Licht |
| 108 | Lichtempfangseinheit |
| 109 | Störsignalableitschicht |
| 110, 111 | Empfängerbondierungsanschlüsse |
| 112 | Substrat |
| 113 | Koppelschicht |
| 201 | Isolationsschicht |
| 202 | Abdeckungsschicht |
| 203 | Anodenleiterbahn |
| 301 | Eingangsschaltkreis |
| 302 | Ausgangsschaltkreis |
| 303 | Eingangssignalleitungen |
| 304 | Ausgangssignalleitungen |
| 401 | Einzelkoppelelement |

## Patentansprüche

1. Optoelektronische Koppelvorrichtung zur optischen Kopplung eines Eingangsschaltkreises (301) mit einem Ausgangsschaltkreis (302) mit:
a) einer Lichtsendeeinheit (101), die aus einer organischen lichtemittierenden Schicht (102), einer Kathodenschicht (103) und einer Anodenschicht (104) gebildet ist, zur Aussendung von Licht (107), wobei die organische lichtemittierende Schicht (102) zwischen der Kathodenschicht (103) und der Anodenschicht (104) angeordnet ist;
b) Senderbondierungsanschlüssen (105, 106), die auf der Kathodenschicht (103) und auf der Anodenschicht (104) aufgebracht sind, zur elektrischen Verbindung der Lichtsendeeinheit (101) mit dem Eingangsschaltkreis (301);
c) einer Lichtempfangseinheit (108) in einem Substrat (112), die in einem Substrat (112) ausgebildet ist, zur Erfassung von Licht (107) von der Lichtsendeeinheit (101);
d) einer Störsignalableitschicht (109), die auf der Lichtempfangseinheit (108) ausgebildet ist, zur elektrischen Ableitung von Störungen abzuleiten;
e) Empfängerbondierungsanschlüssen (109, 110), die auf dem Substrat (112) aufgebracht sind, zur elektrischen Verbindung der Lichtempfangseinheit (108) mit dem Ausgangsschaltkreis (302); und
f) einer Koppelschicht (113), die aus einem lichtdurchlässigen Isoliermaterial gebildet ist, und die zwischen der Anodenschicht (104) der Lichtsendeeinheit (101) und der Störsignalableitschicht (109), die auf der Lichtempfangseinheit (108) ausgebildet ist, angeordnet ist, zur galvanischen Trennung der Lichtsendeeinheit (101) von der Lichtempfangseinheit (108),
wobei die Lichtsendeeinheit (101), die Koppelschicht (113) und die Lichtempfangseinheit (108) als eine Einheit auf einem einzigen Substrat (112) ausgebildet sind.

2. Optoelektronische Koppelvorrichtung zur optischen Kopplung eines Eingangsschaltkreises (301) mit einem Ausgangsschaltkreis (302) nach Anspruch 1,
**dadurch gekennzeichnet ,**
**dass** eine Isolationsschicht (201) zur Isolation der Kathodenschicht (103) von der Anodenschicht (104) der Lichtsendeeinheit aus Polyimid gebildet ist.

3. Optoelektronische Koppelvorrichtung zur optischen Kopplung eines Eingangsschaltkreises (301) mit einem Ausgangsschaltkreis (302) nach einem oder beiden der Ansprüche 1 und 2,
**dadurch gekennzeichnet,**
**dass** die Kathodenschicht (103) der Lichtsendeeinheit (101) aus AlCa gebildet ist.

4. Optoelektronische Koppelvorrichtung zur optischen Kopplung eines Eingangsschaltkreises (301) mit einem Ausgangsschaltkreis (302) nach einem oder mehreren der Ansprüche 1 bis 3,
**dadurch gekennzeichnet,**
**dass** die Anodenschicht (104) der Lichtsendeeinheit (101) aus einem ITO-Material gebildet ist.

5. Optoelektronische Koppelvorrichtung zur optischen Kopplung eines Eingangsschaltkreises (301) mit einem Ausgangsschaltkreis (302) nach einem oder mehreren der Ansprüche 1 bis 4,
**dadurch gekennzeichnet ,**
**dass** die Koppelschicht (113) zur galvanischen Trennung der Lichtsendeeinheit (101) von der Lichtempfangseinheit (108) aus einem elektrischen Isolatormaterial wie beispielsweise Polyimid oder Glas gebildet ist.

6. Optoelektronische Koppelvorrichtung zur optischen Kopplung eines Eingangsschaltkreises (301) mit einem Ausgangsschaltkreis (302) nach einem oder mehreren der Ansprüche 1 bis 5,
**dadurch gekennzeichnet ,**
**dass** der Eingangsschaltkreis (301) als ein Treiberbaustein ausgebildet ist, der die Lichtsendeeinheit treibt.

7. Optoelektronische Koppelvorrichtung zur optischen Kopplung eines Eingangsschaltkreises (301) mit einem Ausgangsschaltkreis (302) nach einem oder mehreren der Ansprüche 1 bis 5,
**dadurch gekennzeichnet,**
**dass** der Ausgangsschaltkreis (302) als ein Chip ausgebildet ist, um eine Mehrfach-Chip-Verpackung bereitzustellen.

8. Optoelektronische Koppelvorrichtung zur optischen Kopplung eines Eingangsschaltkreises (301) mit einem Ausgangsschaltkreis (302) nach einem oder mehreren der Ansprüche 1 bis 7,
**dadurch gekennzeichnet,**
**dass** die optoelektronische Koppelvorrichtung mittels einer Abdeckungsschicht (202), die aus Aluminium (Al) besteht, gekapselt ist.

9. Optoelektronische Koppelvorrichtung zur optischen Kopplung eines Eingangsschaltkreises (301) mit einem Ausgangsschaltkreis (302) nach einem oder mehreren der Ansprüche 1 bis 8,
**dadurch gekennzeichnet,**
**dass** ein Koppelpfad als eine Isolierstrecke auf Wafer-Ebene bereitgestellt ist.

10. Optoelektronische Koppelvorrichtung zur optischen Kopplung eines Eingangsschaltkreises (301) mit einem Ausgangsschaltkreis (302) nach einem oder mehreren der Ansprüche 1 bis 9,
**dadurch gekennzeichnet,**
**dass** die Lichtempfangseinheit (108) als ein mittels eines standardisierten Silizium-Prozesses hergestellter Fototransistor bereitgestellt ist.

11. Herstellungsverfahren für eine optoelektronische Koppelvorrichtung zur optischen Kopplung eines Eingangsschaltkreises (301) mit einem Ausgangsschaltkreis (302), mit den folgenden Schritten:
a) Ausbilden einer Lichtempfangseinheit (108) auf einem Substrat (112) mittels eines standardisierten Silizium-Prozesses;
b) Bondieren von Empfängerbondierungsanschlüssen (110, 111) auf das Substrat (112), damit die Lichtempfangseinheit (108) mit dem Ausgangsschaltkreis (302) elektrisch verbindbar ist;
c) Aufbringen einer lichtdurchlässigen, elektrisch leitfähigen Störsignalableitschicht (109) auf der mittels eines standardisierten Silizium-Prozesses ausgebildeten Lichtempfangseinheit (108) zum elektrischen Ableiten von Störsignalen;
d) Aufbringen einer lichtdurchlässigen, elektrisch isolierenden Koppelschicht (113) auf der lichtdurchlässigen, elektrisch leitfähigen Störsignalableitschicht (109), um die Lichtsendeeinheit (101) und die Lichtempfangseinheit (108) galvanisch voneinander zu trennen;
e) Aufbringen einer Anodenschicht (104) einer Lichtsendeeinheit (101) auf der lichtdurchlässigen, elektrisch isolierenden Koppelschicht (113);
f) Aufbringen einer organischen, lichtemittierenden Schicht (102) auf der Anodenschicht (104) der Lichtsendeeinheit (101);
g) Aufbringen einer Kathodenschicht (103) der Lichtsendeeinheit (101) auf der organischen, lichtemittierenden Schicht (102);
h) Aufbringen einer Abdeckungsschicht (201) auf der Lichtsendeeinheit (101), um die lichtemittierende Schicht (102) hermetisch abzudecken und sowohl die Kathodenschicht (103) als auch die Abdeckschicht (102) von der Anodenschicht (104) elektrisch zu isolieren;
i) Aufbringen einer Abdeckungsschicht (202) auf der Lichtsendeeinheit (101), um die optoelektronische Koppelvorrichtung hermetisch zu schützen;
j) Bondieren von Senderbondierungsanschlüssen (105, 106) auf die Kathodenschicht (103) und auf die Anodenschicht (104), damit die Lichtsendeeinheit (101) mit dem Eingangsschaltkreis (301) elektrisch verbindbar ist; und
k) Sägen des Substrats (112) entlang von Sägegräben, die zwischen den einzelnen optoelektronischen Koppelvorrichtungen bereitgestellt sind, um EinzelChip-Koppelvorrichtungen oder Mehrfach-Chip-Koppelvorrichtungen zu erhalten.

12. Herstellungsverfahren für eine optoelektronische Koppelvorrichtung nach Anspruch 11,
**dadurch gekennzeichnet,**
**dass** die optoelektronische Koppelvorrichtung auf Wafer-Ebene hergestellt und getestet wird.

13. Herstellungsverfahren für eine optoelektronische Koppelvorrichtung nach einem oder beiden der Ansprüche 11 und 12,
**dadurch gekennzeichnet,**
**dass** als Koppelschicht (113) eine isolierende Polyimidschicht einer Dicke von 1-10 µm bereitgestellt wird.

14. Herstellungsverfahren für eine optoelektronische Koppelvorrichtung nach einem oder mehreren der Ansprüche 11 bis 13,
**dadurch gekennzeichnet,**
**dass** die die optoelektronische Koppelvorrichtung ausbildenden Schichten beim Aufbringen strukturiert werden.

15. Herstellungsverfahren für eine optoelektronische Koppelvorrichtung nach einem oder mehreren der Ansprüche 11 bis 14,
**dadurch gekennzeichnet,**
**dass** die Anodenschicht (104) durch ein Sputtern von ITO-Material aufgebracht wird.

16. Herstellungsverfahren für eine optoelektronische Koppelvorrichtung nach einem oder mehreren der Ansprüche 11 bis 15,
**dadurch gekennzeichnet,**
**dass** die Anodenschicht (104) in einer Dicke von 50-200 nm abgeschieden wird.

17. Herstellungsverfahren für eine optoelektronische Koppelvorrichtung nach einem oder mehreren der Ansprüche 11 bis 16,
**dadurch gekennzeichnet,**
**dass** die organische lichtemittierende Schicht (102) durch eine Spin-Beschichtung mit einer Dicke von 200 nm aufgebracht wird.

18. Herstellungsverfahren für eine optoelektronische Koppelvorrichtung nach einem oder mehreren der Ansprüche 11 bis 17,
**dadurch gekennzeichnet,**
**dass** die Kathodenschicht (103) durch ein Aufdampfen von AlCa mit einer Dicke von 200 nm aufgebracht wird.

## Claims

1. Optoelectronic coupling device for optically coupling an input circuit (301) to an output circuit (302) comprising:
a) a light transmitting unit (101), which is formed from an organic light-emitting layer (102), a cathode layer (103) and an anode layer (104), for emitting light (107), the organic light-emitting layer (102) being arranged between the cathode layer (103) and the anode layer (104);
b) transmitter bonding connections (105, 106), which are applied on the cathode layer (103) and on the anode layer (104), for electrically connecting the light transmitting unit (101) to the input circuit (301);
c) a light receiving unit (108) in a substrate (112), which unit is formed in a substrate (112), for detecting light (107) from the light transmitting unit (101);
d) an interference signal conducting-away layer (109), which is formed on the light receiving unit (108), for electrically conducting away interference;
e) receiver bonding connections (109, 110), which are applied on the substrate (112), for electrically connecting the light receiving unit (108) to the output circuit (302); and
f) a coupling layer (113), which is formed from a light-transmissive insulating material, and which is arranged between the anode layer (104) of the light transmitting unit (101) and the interference signal conducting-away layer (109) formed on the light receiving unit (108), for electrically isolating the light transmitting unit (101) from the light receiving unit (108),
the light transmitting unit (101), the coupling layer (113) and the light receiving unit (108) being formed as one unit on a single substrate (112).

2. Optoelectronic coupling device for optically coupling an input circuit (301) to an output circuit (302) according to Claim 1,
**characterized**
**in that** an insulation layer (201) for insulating the cathode layer (103) from the anode layer (104) of the light transmitting unit is formed from polyimide.

3. Optoelectronic coupling device for optically coupling an input circuit (301) to an output circuit (302) according to one or both of Claims 1 and 2,
**characterized**
**in that** the cathode layer (103) of the light transmitting unit (101) is formed from AlCa.

4. Optoelectronic coupling device for optically coupling an input circuit (301) to an output circuit (302) according to one or more of Claims 1 to 3,
**characterized**
**in that** the anode layer (104) of the light transmitting unit (101) is formed from an ITO material.

5. Optoelectronic coupling device for optically coupling an input circuit (301) to an output circuit (302) according to one or more of Claims 1 to 4,
**characterized**
**in that** the coupling layer (113) for electrically isolating the light transmitting unit (101) from the light receiving unit (108) is formed from an electrical insulator material such as, for example, polyimide or glass.

6. Optoelectronic coupling device for optically coupling an input circuit (301) to an output circuit (302) according to one or more of Claims 1 to 5,
**characterized**
**in that** the input circuit (301) is formed as a driver component that drives the light transmitting unit.

7. Optoelectronic coupling device for optically coupling an input circuit (301) to an output circuit (302) according to one or more of Claims 1 to 5,
**characterized**
**in that** the output circuit (302) is formed as a chip in order to provide a multiple chip packaging.

8. Optoelectronic coupling device for optically coupling an input circuit (301) to an output circuit (302) according to one or more of Claims 1 to 7,
**characterized**
**in that** the optoelectronic coupling device is encapsulated by means of a covering layer (202) comprising aluminium (A1).

9. Optoelectronic coupling device for optically coupling an input circuit (301) to an output circuit (302) according to one or more of Claims 1 to 8,
**characterized**
**in that** a coupling path is provided as an insulating clearance at the wafer level.

10. Optoelectronic coupling device for optically coupling an input circuit (301) to an output circuit (302) according to one or more of Claims 1 to 9,
**characterized**
**in that** the light receiving unit (108) is provided as a phototransistor fabricated by means of a standardized silicon process.

11. Fabrication method for an optoelectronic coupling device for optically coupling an input circuit (301) to an output circuit (302), comprising the following steps:
a) forming a light receiving unit (108) on a substrate (112) by means of a standardized silicon process;
b) bonding receiver bonding connections (110, 111) onto the substrate (112) in order that the light receiving unit (108) can be electrically connected to the output circuit (302);
c) applying a light-transmissive, electrically conductive interference signal conducting-away layer (109) on the light receiving unit (108) formed by means of a standardized silicon process, for electrically conducting away interference signals;
d) applying a light-transmissive, electrically insulating coupling layer (113) on the light-transmissive, electrically conductive interference signal conducting-away layer (109) in order to electrically isolate the light transmitting unit (101) and the light receiving unit (108) from one another;
e) applying an anode layer (104) of a light transmitting unit (101) on the light-transmissive, electrically insulating coupling layer (113);
f) applying an organic light-emitting layer (102) on the anode layer (104) of the light transmitting unit (101);
g) applying a cathode layer (103) of the light transmitting unit (101) on the organic light-emitting layer (102);
h) applying a covering layer (201) on the light transmitting unit (101) in order to hermetically cover the light-emitting layer (102) and to electrically insulate both the cathode layer (103) and the covering layer (102) from the anode layer (104);
i) applying a covering layer (202) on the light transmitting unit (101) in order to hermetically protect the optoelectronic coupling device;
j) bonding transmitter bonding connections (105, 106) onto the cathode layer (103) and onto the anode layer (104) in order that the light transmitting unit (101) can be electrically connected to the input circuit (301); and
k) sawing the substrate (112) along sawing trenches provided between the individual optoelectronic coupling devices, in order to obtain single-chip coupling devices or multiple-chip coupling devices.

12. Fabrication method for an optoelectronic coupling device according to Claim 11,
**characterized**
**in that** the optoelectronic coupling device is fabricated and tested at the wafer level.

13. Fabrication method for an optoelectronic coupling device according to one or both of Claims 11 and 12,
**characterized**
**in that** an insulating polyimide layer having a thickness of 1-10 µm is provided as the coupling layer (113).

14. Fabrication method for an optoelectronic coupling device according to one or more of Claims 11 to 13,
**characterized**
**in that** the layers forming the optoelectronic coupling device are patterned during application.

15. Fabrication method for an optoelectronic coupling device according to one or more of Claims 11 to 14,
**characterized**
**in that** the anode layer (104) is applied by sputtering ITO material.

16. Fabrication method for an optoelectronic coupling device according to one or more of Claims 11 to 15,
**characterized**
**in that** the anode layer (104) is deposited with a thickness of 50-200 nm.

17. Fabrication method for an optoelectronic coupling device according to one or more of Claims 11 to 16,
**characterized**
**in that** the organic light-emitting layer (102) is applied by spin coating with a thickness of 200 nm.

18. Fabrication method for an optoelectronic coupling device according to one or more of Claims 11 to 17,
**characterized**
**in that** the cathode layer (103) is applied by vapour-depositing AlCa with a thickness of 200 nm.

## Revendications

1. Dispositif de couplage optoélectronique pour le couplage optique d'un circuit d'entrée (301) à un circuit de sortie (302) avec :
a) une unité émettrice de lumière (101) qui est formée d'une couche électroluminescente organique (102), d'une couche cathodique (103) et d'une couche anodique (104), pour l'émission d'une lumière (107), la couche électroluminescente organique (102) étant placée entre la couche cathodique (103) et la couche anodique (104) ;
b) des bornes de connexion d'émetteur (105, 106), qui sont appliquées sur la couche cathodique (103) et sur la couche anodique (104), pour la liaison électrique de l'unité émettrice de lumière (101) au circuit d'entrée (301) ;
c) une unité réceptrice de lumière (108) dans un substrat (112), qui est conçue dans un substrat (112), pour la détection d'une lumière (107) de la couche émettrice de lumière (101) ;
d) une couche de déviation de signal parasite (109), qui est conçue sur l'unité réceptrice de lumière (108), pour la déviation électrique de parasites ;
e) des bornes de connexion de récepteur (109, 110), qui sont appliquées sur le substrat (112), pour la liaison électrique de la couche réceptrice de lumière (108) au circuit de sortie (302) ; et
f) une couche de couplage (113), qui est formée d'un matériau isolant transparent à la lumière, et qui est placée entre la couche anodique (104) de l'unité émettrice de lumière (101) et la couche de déviation de signal parasite (109) conçue sur la couche réceptrice de lumière (108), pour l'isolation électrique entre l'unité émettrice de lumière (101) et l'unité réceptrice de lumière (108),
l'unité émettrice de lumière (101), la couche de couplage (113) et l'unité réceptrice de lumière (108) étant conçues comme une seule unité sur un seul substrat (112).

2. Dispositif de couplage optoélectronique pour le couplage optique d'un circuit d'entrée (301) à un circuit de sortie (302) selon la revendication 1,
**caractérisé par le fait qu'**une couche isolante (201) pour l'isolation entre la couche cathodique (103) et la couche anodique (104) de l'unité émettrice de lumière est formée en polyimide.

3. Dispositif de couplage optoélectronique pour le couplage optique d'un circuit d'entrée (301) à un circuit de sortie (302) selon l'une ou les deux des revendications 1 et 2,
**caractérisé par le fait que** la couche cathodique (103) de l'unité émettrice de lumière (101) est formée en AlCa.

4. Dispositif de couplage optoélectronique pour le couplage optique d'un circuit d'entrée (301) à un circuit de sortie (302) selon l'une ou plusieurs des revendications 1 à 3,
**caractérisé par le fait que** la couche anodique (104) de l'unité émettrice de lumière (101) est formée en un matériau ITO.

5. Dispositif de couplage optoélectronique pour le couplage optique d'un circuit d'entrée (301) à un circuit de sortie (302) selon l'une ou plusieurs des revendications 1 à 4,
**caractérisé par le fait que** la couche de couplage (113) est formée, pour l'isolation électrique entre l'unité émettrice de lumière (101) et l'unité réceptrice de lumière (108), en un matériau isolant électrique, par exemple du polyimide ou du verre.

6. Dispositif de couplage optoélectronique pour le couplage optique d'un circuit d'entrée (301) à un circuit de sortie (30-2) selon l'une ou plusieurs des revendications 1 à 5,
**caractérisé par le fait que** le circuit d'entrée (301) est conçu comme un composant d'attaque qui pilote l'unité émettrice de lumière.

7. Dispositif de couplage optoélectronique pour le couplage optique d'un circuit d'entrée (301) à un circuit de sortie (302) selon l'une ou plusieurs des revendications 1 à 5,
**caractérisé par le fait que** le circuit de sortie (302) est conçu comme une puce pour fournir un agencement à puces multiples.

8. Dispositif de couplage optoélectronique pour le couplage optique d'un circuit d'entrée (301) à un circuit de sortie (302) selon l'une ou plusieurs des revendications 1 à 7,
**caractérisé par le fait que** le dispositif de couplage optoélectronique est encapsulé au moyen d'une couche de couverture (202) qui est en aluminium (A1).

9. Dispositif de couplage optoélectronique pour le couplage optique d'un circuit d'entrée (301) à un circuit de sortie (302) selon l'une ou plusieurs des revendications 1 à 8,
**caractérisé par le fait qu'**un trajet de couplage est fourni comme voie isolante sur le plan de la tranche de silicium.

10. Dispositif de couplage optoélectronique pour le couplage optique d'un circuit d'entrée (301) à un circuit de sortie (302) selon l'une ou plusieurs des revendications 1 à 9,
**caractérisé par le fait que** l'unité réceptrice de lumière (108) est fournie comme un phototransistor fabriqué au moyen d'un processus normalisé à base de silicium.

11. Procédé de fabrication d'un dispositif de couplage optoélectronique pour le couplage optique d'un circuit d'entrée (301) à un circuit de sortie (302), avec les étapes suivantes:
a) conception d'une unité réceptrice de lumière (108) sur un substrat (112) au moyen d'un processus normalisé à base de silicium ;
b) liaison de bornes de connexion de récepteur (110, 111) sur le substrat (112) pour que l'unité réceptrice de lumière (108) puisse être reliée électriquement au circuit de sortie (302) ;
c) application d'une couche de déviation de signal parasite (109), transparente à la lumière et électriquement conductrice, sur l'unité réceptrice de lumière (108), conçue au moyen d'un processus normalisé à base de silicium, pour la déviation électrique de signaux parasites;
d) application d'une couche de couplage (113), transparente à la lumière et électriquement isolante, sur la couche de déviation de signal parasite (109), transparente à la lumière et électriquement conductrice, pour isoler électriquement l'une de l'autre l'unité émettrice de lumière (101) et l'unité réceptrice de lumière (108) ;
e) application d'une couche anodique (104) d'une unité émettrice de lumière (101) sur la couche de couplage (113), transparente à la lumière et électriquement isolante ;
f) application d'une couche électroluminescente organique (102) sur la couche anodique (104) de l'unité émettrice de lumière (101) ;
g) application d'une couche cathodique (103) de l'unité émettrice de lumière (101) sur la couche électroluminescente organique (102) ;
h) application d'une couche de couverture (201) sur l'unité émettrice de lumière (101) pour couvrir hermétiquement la couche électroluminescente (102) et pour isoler électriquement de la couche anodique (104) aussi bien la couche cathodique (103) que la couche électroluminescente (102) ;
i) application d'une couche de couverture (202) sur l'unité émettrice de lumière (101) pour protéger hermétiquement le dispositif de couplage optoélectronique ;
j) liaison de bornes de connexion d'émetteur (105, 106) sur la couche cathodique (103) et sur la couche anodique (104) pour que l'unité émettrice de lumière (101) puisse être reliée électriquement au circuit d'entrée (301) ; et
k) sciage du substrat (112) le long de tranchées de sciage qui sont préparées entre les dispositifs de couplage optoélectronique individuels pour obtenir des dispositifs de couplage à une seule puce ou des dispositifs de couplage à plusieurs puces.

12. Procédé de fabrication d'un dispositif de couplage optoélectronique selon la revendication 11,
**caractérisé par le fait que** le dispositif de couplage optoélectronique est fabriqué et testé sur le plan de la tranche de silicium.

13. Procédé de fabrication d'un dispositif de couplage optoélectronique selon l'une ou les deux des revendications 11 et 12,
**caractérisé par le fait qu'**une couche isolante en polyimide d'une épaisseur de 1 à 10 *µ*m est fournie comme couche de couplage (113).

14. Procédé de fabrication d'un dispositif de couplage optoélectronique selon l'une ou plusieurs des revendications 11 à 13,
**caractérisé par le fait que** les couches formant le dispositif de couplage optoélectronique sont structurées lors de l'application.

15. Procédé de fabrication d'un dispositif de couplage optoélectronique selon l'une ou plusieurs des revendications 11 à 14,
**caractérisé par le fait que** la couche anodique (104) est appliquée par pulvérisation de matériau ITO.

16. Procédé de fabrication d'un dispositif de couplage optoélectronique selon l'une ou plusieurs des revendications 11 à 15,
**caractérisé par le fait que** la couche anodique (104) est déposée sur une épaisseur de 50 à 200 nm.

17. Procédé de fabrication d'un dispositif de couplage optoélectronique selon l'une ou plusieurs des revendications 11 à 16,
**caractérisé par le fait que** la couche électroluminescente organique (102) est appliquée par un revêtement spin sur une épaisseur de 200 nm.

18. Procédé de fabrication d'un dispositif de couplage optoélectronique selon l'une ou plusieurs des revendications 11 à 17,
**caractérisé par le fait que** la couche cathodique (103) est appliquée par vaporisation de AlCa sur une épaisseur de 200 nm.
